# EUROPEAN PATENT APPLICATION

(11) **EP 1 923 919 A1**
(43) Date of publication of application: **21.05.2008**
(21) Application number: 06398016.3
(22) Date of filing: 31.10.2006
(51) Int. Cl.: H01L 31/042

(54) **Adaptation of the cover of electrical vehicles for energy supply by means of oa integrated photovoltaic solar system**

(71) Applicant: Solarcar, Lda., 7000 Evora (PT)
(72) Inventor: Derrick Elbert, Baron Van Voorst tot Voorst, 700 Evora (PT)

(57) **Abstract**

This system consists of a set of electric and mechanic elements that allow the power supply of electric vehicles, through solar photovoltaic energy, which is integrated in the mechanic and electric structure of such vehicles. The purpose of this invention is the supply of solar photovoltaic energy to existing electric vehicles, without modifying or devaluating their aesthetical characteristics. The system is constituted by a photovoltaic panel, a support structure and a control system. The photovoltaic panel, of variable dimensions, is characterized by a set of photovoltaic cells, tailor-made for each vehicle and electrically connected between each other in such a way that its current and output voltage are the most adequate to optimize the electric charging of the batteries.

The support structure is tailor-made for each vehicle so that its aesthetics characteristics remain unchanged. The control system allows an optimization of the electric charging and protects the vehicle batteries against overcharges. The system can be applied, namely, to electric golf caddies and boats.

## Description

### Field of the Invention

This invention refers to the power supply of electric vehicles using solar energy.

### Background of the Invention

The application of solar photovoltaic panels in electric vehicles for power generation purposes has been used for many decades. However, these systems consist of placing photovoltaic modules simply on top of the roof of the vehicle to directly charge its batteries. These systems do not take into consideration aesthetical and structural characteristics of the vehicle.

The present system is different from the previous ones once it is fully integrated in the electrical and mechanical structure of the vehicle. The photovoltaic panel and its frame are tailor-made for each vehicle and substitute the existing covering for a similar one, which will produce the energy used by the vehicle. The electric control is introduced inside the existing structure and with the adequate electric characteristics for the vehicle.

Unlike the previous systems, this innovation is able to generate power supply for electric vehicles using solar energy without significant modifications of the structure of the vehicle in question.

### Detailed description of the invention

The present system consists of a set of electric and mechanic elements that allow the power supply of electric vehicles through a solar photovoltaic energy source, which is integrated in the mechanic and electric structure of the referred to vehicles. The purpose of this system is the supply of solar photovoltaic energy to existing electric vehicles, without modifying or devaluating their aesthetical characteristics.

The set of electric and mechanic elements includes: a solar photovoltaic panel that is designed and electrically dimensioned taking into account the electric and mechanic characteristics of each vehicle, a metallic structure to integrate the photovoltaic panel on the cover of the vehicle and a control system to regulate the electric charge and protect the batteries of the vehicle.

These elements are integrated into existing electric vehicles, thus allowing them to use either the power coming from the system and/or the power coming from the method that they were originally prepared to use.

This system is completely integrated in the structure of the vehicle, and the electric characteristics of the tailor-made photovoltaic panel and the control system optimize the charge-cycles of the batteries, thus permitting a superior level of autonomy when compared to other existing simpler systems.

The photovoltaic panel is formed by two overlapped transparent glass plates, or by one transparent glass plate and one plate made off other non-transparent support material, where the photovoltaic cells are integrated. The cells used in the panel can have different shapes and dimensions and the distance between the cells is variable, which allows creating a certain level of transparency in accordance with the application in question. The cells are electrically connected between each other in such a way that the voltage and output current are the most adequate for charging the batteries of the vehicle.

The control system is composed by a solar converter to raise the voltage and a solar regulator to optimize the output power of the panel and to protect the batteries from overcharges. This control system has reduced dimensions, which will depend on the application, and will be placed close to the batteries, becoming invisible from the outside of the vehicle.

The metal structure is made of aluminium and composed by a frame, which supports the panel and the columns that connect the frame to the vehicle. This structure, together with the photovoltaic panel, will substitute the original cover of the vehicle without any significant aesthetical differences.

The cables that electrically connect the photovoltaic panel to the control system are inserted directly into the columns that connect the cover to the vehicle, and therefore are not visible from the outside of the vehicle.

### Brief description of the drawings

This invention will be described in a more detailed way through the attached drawings, as follows:
Fig. 1 - Drawing of a photovoltaic panel integrated into glass.
Fig. 2 - Presentation of an amplified section of the upper right corner of Figure 1.
Fig. 3 - Presents a transversal cut of the section in Figure 2.
Fig. 4 - Represents the aluminium frame that supports the panel, in three different views.
Fig. 5 - Presents a transversal cut of the aluminium frame connected to the panel and connecting column.
Fig. 6 - Shows the supporting frame with the integrated photovoltaic panel.
Fig. 7 - Shows a block diagram of the electric system to be integrated into the vehicle, being the batteries the ones already existing in the vehicle.

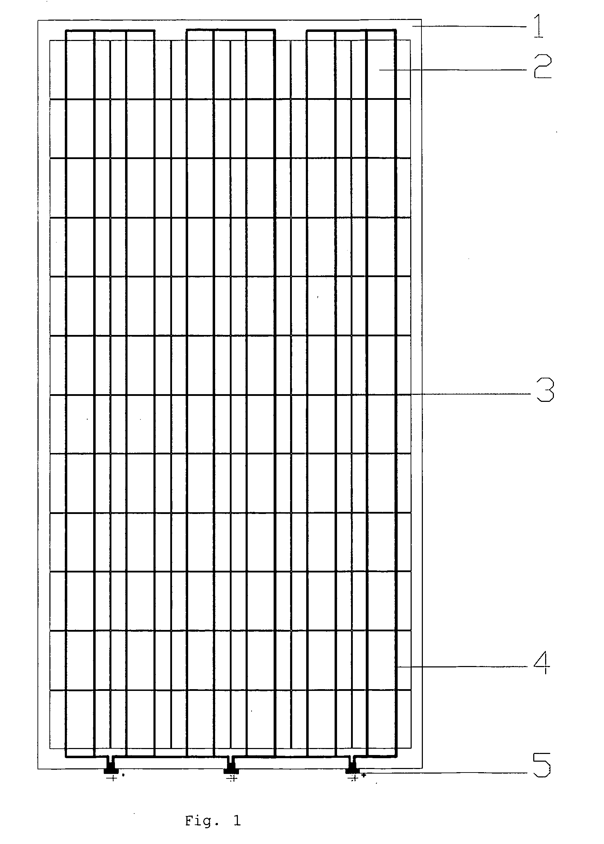

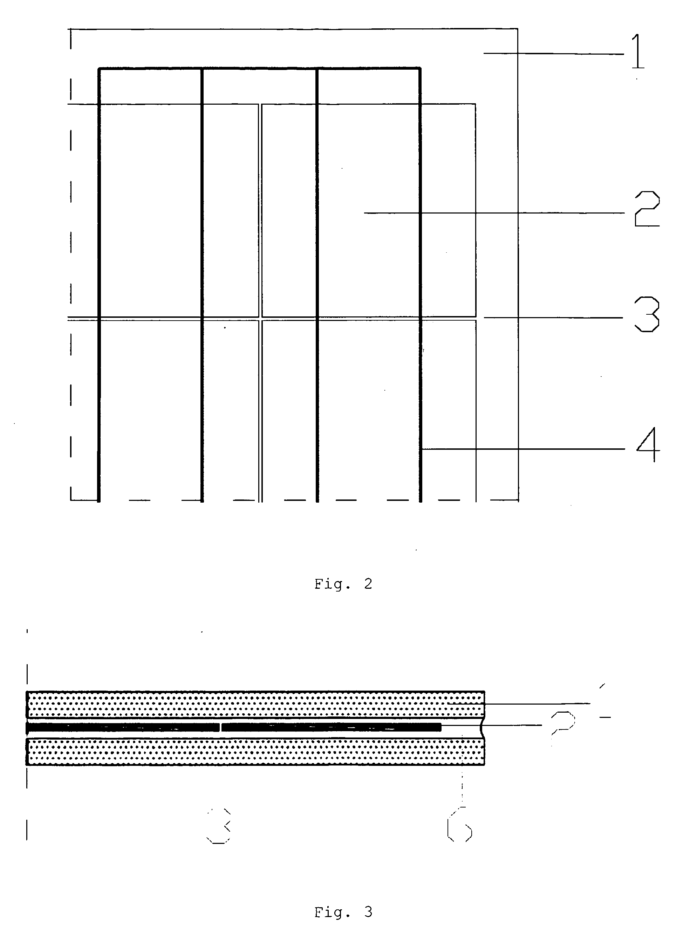

The drawings of Figure 1 and 2 allow the description of several characteristics of the photovoltaic panel, such as: the upper surface in glass (1), the photovoltaic cells (2), the distance between the cells (3), the electric connexions between the cells (4) and the protection diodes of the panel (5). The transversal cut of the panel represented in Figure 3 makes possible to observe the position of the cells (3) between the glass-surfaces (1) and the transparent filling gel (6) which occupies the empty space left by the cells between the upper and lower glass surfaces. The size and number of cells (2) can vary for each different application. The distance between the cells (3) can also vary in order to change light intensity to the inside of the vehicle.

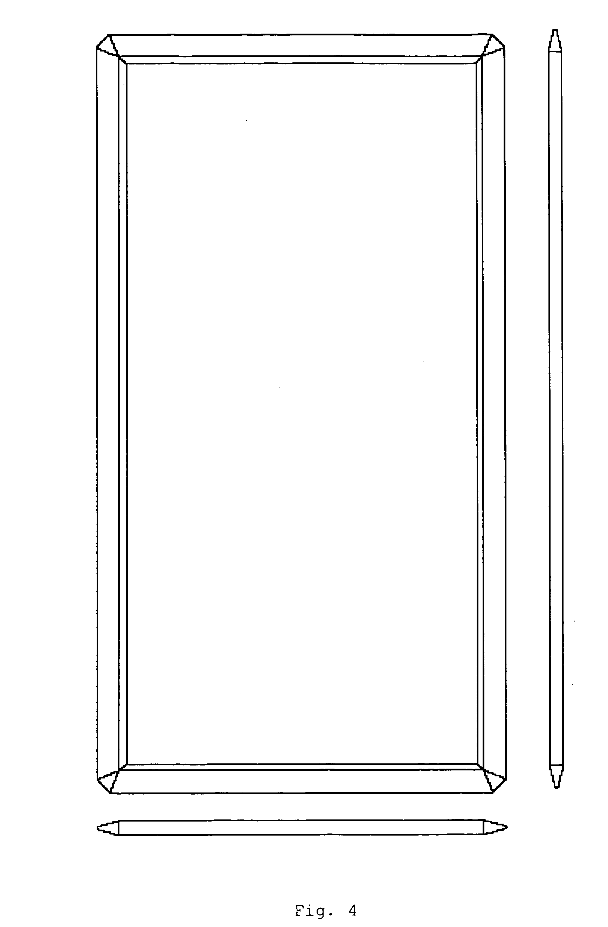

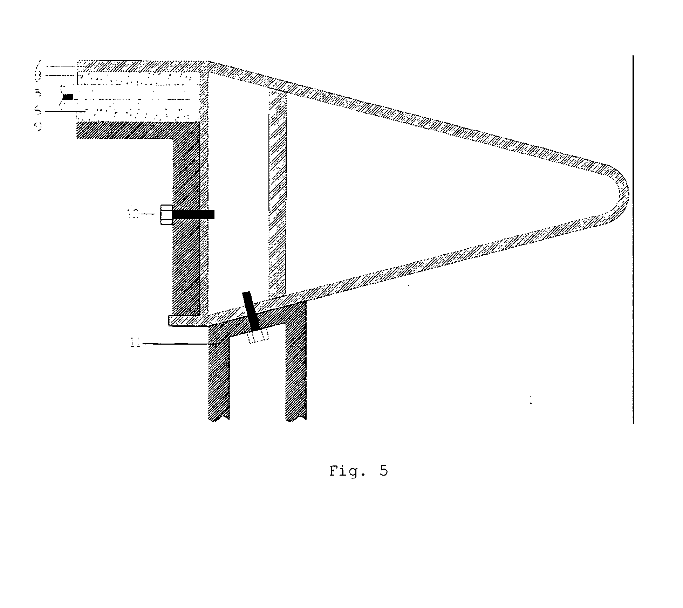

The aluminium frame represented in Figure 4 can have variable dimensions and exterior design in accordance with each application. The fixation system between the panel and the frame is based on the diagram presented in Figure 5 were the panel is tightened to the aluminium structure (7) between two rubber surfaces (8), thus resulting in a waterproof cover. The tightening is done by a metal plate (9) fixed to the aluminium frame through an hexagonal screw (10). The frame will be connected to the vehicle through the support columns (11).

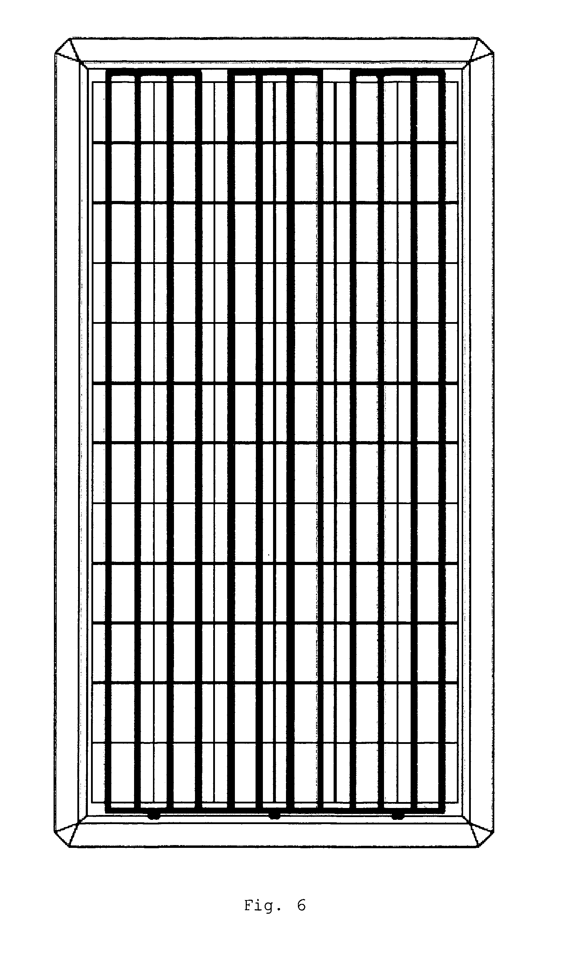

The design presented in Figure 6 shows the panel fixed to the aluminium structure.

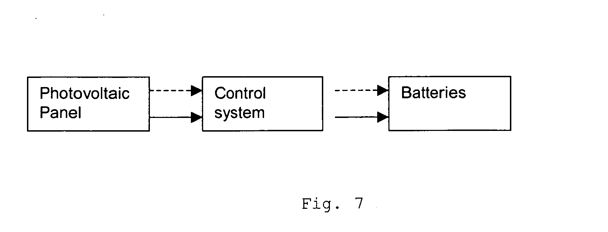

The block diagram of Figure 7 lays out the electric adaptation system; being the photovoltaic panel connected to the control system, which will be connected to the existing batteries in the adapted vehicle. The continuing lines represent the electric current flux, and the dashed lines represent the data flux for the power charge controller.

## Claims

1. - Photovoltaic solar system to power electric vehicles, **characterized by** a photovoltaic panel composed by several photovoltaic cells integrated in one module, transparent or not in accordance with the concrete application, which integrates the structure of the vehicle without substantial aesthetic changes and substitutes the original cover of the vehicle.

2. - The system, as described in claim 1, has a unique tailor-made photovoltaic panel that can vary in size, **characterized by** a set of tailor-made photovoltaic cells electrically connected between each other in such a way that its current and output voltage are the most adequate to optimize the electric charging of the batteries.

3. - The system, as described in claim 1 and 2, has an electronic control system **characterized by** a solar converter and a solar charge regulator that adjusts the current and the output voltage of the photovoltaic panel and protects the vehicle batteries against overcharges.
